# FASCICULE DE BREVET EUROPEEN

(11) **EP 1 386 346 B1**
(45) Date de publication et mention de la délivrance du brevet: **03.08.2005**
(21) Numéro de dépôt: 02722389.0
(22) Date de dépôt: 02.04.2002
(51) Int. Cl.: H01L 21/00, H01L 21/78, H01L 21/304, H01L 21/68

(54) **PROCEDE DE TRANSFERT SELECTIF DE PUCES SEMICONDUCTRICES D'UN SUPPORT INITIAL SUR UN SUPPORT FINAL**
VERFAHREN ZUM SELEKTIVEN TRANSFERIEREN VON HALBLEITER-CHIPS VON EINEM TRÄGER ZU EINEM EMPFANGSSUBSTRAT
METHOD FOR SELECTIVELY TRANSFERRING AT LEAST AN ELEMENT FROM AN INITIAL SUPPORT ONTO A FINAL SUPPORT

(30) Priorité: 03.04.2001 FR 0104502
(43) Date de publication de la demande: 04.02.2004
(73) Titulaire: COMMISSARIAT A L'ENERGIE ATOMIQUE, 75752 Paris Cédex 15 (FR)
(72) Inventeur: FIGUET, Christophe, F-38600 Fontaine (FR); ASPAR, Bernard, F-38100 Rives (FR); BLET, Vincent, F-38240 Meylan (FR)
(74) Mandataire: Poulin, Gérard
(86) Numéro de dépôt international: PCT/FR2002/001132
(87) Numéro de publication internationale: WO 2002/082502

(56) Documents cités:
- FR-A- 2 781 925
- US-A- 5 391 257
- US-A- 5 641 714
- US-A- 6 013 534
- US-A- 6 027 958
- PATENT ABSTRACTS OF JAPAN vol. 2000, no. 08, 6 octobre 2000 (2000-10-06) -& JP 2000 150544 A (HITACHI LTD), 30 mai 2000 (2000-05-30)
- PATENT ABSTRACTS OF JAPAN vol. 1995, no. 07, 31 août 1995 (1995-08-31) -& JP 07 106285 A (OKI ELECTRIC IND CO LTD), 21 avril 1995 (1995-04-21)
- PATENT ABSTRACTS OF JAPAN vol. 1995, no. 06, 31 juillet 1995 (1995-07-31) & JP 07 078795 A (NEC YAMAGUCHI LTD), 20 mars 1995 (1995-03-20)

## Description

### DOMAINE TECHNIQUE

La présente invention concerne le transfert sélectif d'un ou plusieurs éléments, que l'on peut désigner sous le terme générique de vignette, depuis un support de fabrication vers un support de réception.

Elle concerne en particulier le transfert de puces semi-conductrices, partiellement ou complètement achevées, depuis leur substrat initial, sur lequel elles ont été fabriquées vers un nouveau substrat (ou support de réception) qui peut lui-même avoir été traité par les techniques de la microélectronique.

L'invention permet en particulier le transfert de puces qui peuvent avoir été testées électriquement, par exemple le transfert de puces de 1 mm² à 1 cm² de surface, de leur substrat initial vers un support en matériau semi-conducteur traité ou non, vers un support en matériau transparent par exemple en verre, vers un support souple ou rigide par exemple en plastique ou vers un support en matériau céramique. Elle permet aussi par exemple de par exemple transférer des composants optoélectroniques tels que des lasers à cavité verticale et à émission par la surface ou VCSEL (pour « Vertical Cavity Surface Emitting Laser ») ou de petits morceaux de semi-conducteur III-V de leur substrat initial sur des plaquettes de silicium qui peuvent être préparées selon les techniques de la microélectronique afin d'obtenir des éléments semi-conducteurs III-V sur silicium.

Elle peut aussi s'appliquer au report de circuits électroniques, éventuellement testés électriquement et amincis, sur carte plastique par une colle pour la réalisation de cartes à puces.

### ETAT DE LA TECHNIQUE ANTERIEURE

Il existe de nombreuses méthodes permettant de transférer des puces semi-conductrices ou des groupes de puces vers un support de réception. On peut citer la technique dite « epitaxial lift-off », le collage organique ou minéral (par adhésion moléculaire) et la technique dite "flip-chip". Cette dernière méthode ne permet pas de manipuler des composants individuels de petites dimensions et de très faible épaisseur contrairement aux deux précédentes.

La technique du collage minéral ou adhésion moléculaire est connue pour de nombreux matériaux. L'adhésion moléculaire comprend deux différents types de collage : le collage hydrophile et le collage hydrophobe. Dans le cas du collage hydrophile, le collage résulte de l'évolution de l'interaction de groupements -OH à la surface d'une structure vers la formation de liaisons Si-O-Si dans le cas de l'oxyde de silicium. Les forces associées à ce type d'interaction sont fortes. L'énergie de collage, de l'ordre de 100 mJ/m² à température ambiante, atteint 500 mJ/m² après un recuit à 400°C pendant 30 minutes. Dans le cas du collage hydrophobe, le collage résulte de l'évolution de l'interaction de groupements -H ou -F à la surface de la structure vers des liaisons Si-Si dans le cas de l'adhésion de silicium. L'énergie de collage est plus faible que celle des collages hydrophiles jusqu'à des températures de l'ordre de 500-600°C. L'énergie de collage est généralement déterminée par la méthode de la lame divulguée par W.P. Maszara et al., dans l'article « Bonding of silicon wafers for silicon-on-insulator » paru dans J. Appl. Phys. 64(10), 15 novembre 1988, pages 4943 à 4950.

Le contrôle des énergies de collage peut permettre de réaliser des adhésions moléculaires réversibles où, comme divulgué dans le document FR-A-2 781 925, l'énergie d'adhésion des éléments peut être faible sur le support de transfert et les éléments à reporter peuvent être traités pour qu'ils aient une énergie d'adhésion plus forte sur le support de réception que sur le support de transfert permettant ainsi de reporter sélectivement un élément parmi n. Dans ce document, l'énergie d'adhésion est plus faible entre les éléments à transférer et le support de transfert qu'entre les éléments et le support de réception. Or, l'énergie que l'on obtient lors du collage entre les éléments et le support de réception est une énergie d'adhésion à température ambiante donc comprise entre 0 et 200 mJ/m² suivant les traitements de surface et les matériaux utilisés. L'énergie de liaison entre les éléments à reporter et le support de transfert est donc obligatoirement inférieure à 200 mJ/m². La méthode décrite dans ce document ne permet pas de reporter des éléments fortement adhérés sur le support de transfert, par exemple à des énergies supérieures à 200 mJ/m².

Le document FR-A-2 796 491 divulgue le report sur un substrat final de puces manipulées individuellement sur un support de transfert sur lequel elles ont été préalablement collées. Les puces sont manipulées individuellement sur le support de transfert grâce à des ouvertures pratiquées à travers celui-ci et qui le traversent entièrement. Une action mécanique (par exemple à l'aide d'un pointeau), chimique ou pneumatique, voire une de leurs combinaisons, permet de désolidariser une puce du support de transfert et de venir l'adhérer sur le support de réception. Cette approche peut s'appliquer à une adhésion faible d'une puce sur le substrat de transfert et forte sur le support de réception. Elle nécessite la réalisation d'un support de transfert spécial qui a été conditionné pour permettre la sélection de chaque élément à transférer. En outre, elle n'est pas compatible avec les équipements standard de la microélectronique comme les équipements de "pick and place"

Les documents US-A-6 027 958 et WO-A-98/02921 divulguent le report d'éléments fins processés sur substrat SOI dans le but d'augmenter la densité d'intégration et pour rendre les composants moins fragiles. Dans un premier temps, les composants sont réalisés par les technologies classiques de la microélectronique puis reliés entre eux par un dépôt métallique. Selon cette méthode, les éléments a transférer sont adhérés sur un support de transfert, sur lequel une couche d'arrêt chimique a été déposée, par un matériau adhésif. Le substrat initial est enlevé pour découvrir la couche d'arrêt. Les composants sont ensuite solidarisés collectivement sur un support de réception. Puis, le support de transfert est enlevé.

Cette méthode permet de reporter un ensemble de composants en couche mince vers un support de réception. Les composants ne sont pas individualisés dans le transfert. Il s'agit donc d'un procédé collectif. Les composants, dans cette méthode de transfert, sont conservés ensemble et avec un support épais qui permet de les manipuler. Jamais un composant individuel ne peut être séparé des autres à cause des substrats épais (substrat initial, support de transfert, support de réception) qui sont toujours en contact avec les composants. Cette méthode ne permet donc pas un report sélectif d'un élément en couche mince.

La technique dite "epitaxial lift-off" permet de reporter de manière individuelle un composant. Une première étape consiste à réaliser par épitaxie des composants à transférer (voir le brevet américain N° 4 883 561 dans le cas du simple transfert). Les couches épitaxiales peuvent être inversées (voir le brevet américain N° 5 401 983 dans le cas du double transfert). Avant la formation de l'ensemble des couches constitutives du composant, une couche sacrificielle est épitaxiée sur le substrat de croissance. Les vignettes sont définies par photolithographie. Une résine est déposée sur les vignettes de façon à les contraindre et à leur donner une structure concave pour le renouvellement de la solution de sous-gravure et l'évacuation des résidus d'attaque. La couche sacrificielle est ensuite attaquée chimiquement par voie humide. Comme le film constitué par les couches épitaxiées est contraint par la résine, celui-ci se courbe petit à petit, ce qui permet à la solution d'attaque de pénétrer dans l'interstice en formation entre le film et le substrat. Lorsque l'attaque est terminée, le film peut être récupéré par une pince à vide pour être transféré sur un substrat cible (voir le brevet américain N° 4 883 561) ou sur un support de transfert (voir le brevet américain N° 5 401 983). Après le report, la résine est éliminée chimiquement puis les vignettes, reportées sur le substrat de réception, sont traitées thermiquement sous pression pour éliminer les gaz piégés à l'interface.

Dans cette technique, la couche sacrifiée est une couche épitaxiée, d'où la désignation "epitaxial lift-off". Les éléments peuvent être transférés individuellement ou collectivement sur un support de transfert et être solidarisés sur un support de réception par des forces de van der Waals, puis recuits lorsque le support de transfert a été enlevé. Cette technique présente l'avantage principal de récupérer le substrat initial. Cependant, à cause de la sous-gravure latérale de la couche sacrificielle, les dimensions des puces à transférer sont limitées. L'article de E. YABLONOVITCH et al., Appl. Phys. Lett. 56(24), 1990, page 2419 mentionne une taille maximale de 2 cm × 4 cm et des temps d'attaque chimique assez long. La vitesse maximale serait de 0,3 mm/h dans le cas des faibles dimensions latérales (inférieures à 1 cm). De plus, comme cette vitesse d'attaque dépend de la courbure des éléments à reporter pour l'évacuation des résidus d'attaque, elle limite l'épaisseur des composants transférables à 4,5 µm (voir l'article de K.H. CALHOUN et al., IEEE Photon. Technol. Lett., février 1993).

La technique du "lift-off" est connue depuis de nombreuses années (voir par exemple le brevet américain N° 3 943 003). Cette technique comprend le dépôt d'une résine photosensible épaisse sur un substrat, l'insolation et l'ouverture de cette résine aux endroits où l'on souhaite déposer un matériau qui est en général un métal. Le matériau est déposé par une méthode de dépôt à froid (en général par pulvérisation) sur toute la surface du substrat. Le matériau déposé n'adhère réellement qu'aux endroits où la résine a été ouverte. La résine est ensuite dissoute dans un solvant (par exemple de l'acétone) et seules les parties adhérentes du matériau subsistent.

D'autres méthodes sont proposées dans le document EP-A-1 041 620. Elles permettent de reporter des puces minces sur un support hôte. Ces méthodes sont basées sur le traitement individuel des puces. Les puces sont collées une par une sur un support de transfert, sont amincies individuellement puis reportées sur un support hôte. Il ne s'agit pas d'un traitement collectif pour l'amincissement puis le report individuel à partir du substrat.

### EXPOSÉ DE L'INVENTION

L'invention a pour objet le report sélectif de vignettes (c'est-à-dire un élément ou un groupe d'éléments) réalisées préférentiellement en couches minces homogènes ou hétérogènes depuis un support initial, qui peut être un support de fabrication, jusqu'à un support final. Elle permet en particulier le transfert de puces électroniques qui peuvent être réalisées à partir de n'importe quel matériau semi-conducteur. Il peut s'agir d'un ou de plusieurs lasers du type VCSEL, d'un ou de plusieurs photodétecteurs en cavité ou d'une combinaison de photodétecteurs et de lasers. Il peut aussi s'agir d'un ou de plusieurs composants électroniques, de circuits pour cartes à puce, de transistors de commande d'écran plat ou TFT (pour "Thin Film Transistors"), de dispositifs à mémoire ou d'une combinaison de composants ayant une fonction opto-électronique, électronique ou mécanique (MEMS) entre eux, etc.

L'invention permet le transfert d'une puce comprenant un ou plusieurs lasers du type VCSEL réalisés et testés électriquement sur un substrat de fabrication (en GaAs ou InP par exemple) vers un circuit de lecture et d'adressage réalisé sur silicium. Dans une autre application, l'invention permet le transfert de composants optoélectroniques sur un support de réception n'ayant qu'une fonction optique comme un verre, un guide d'onde, etc. Elle permet aussi le report d'un élément semi-conducteur comprenant un circuit électronique sur un support de réception qui sert à la manipulation des fonctions réalisées par le circuit électronique, comme par exemple une carte à puce. Ce report présente plusieurs avantages dont le principal est de pouvoir intégrer une fonction électronique ou optique ou optoélectronique ou mécanique sur un substrat sur lequel elle ne peut être réalisée avec la qualité requise par épitaxie, par dépôt ou par tout autre moyen de réalisation utilisé en microélectronique.

Il est évident que la croissance épitaxiale de composants présentant une forte différence de paramètre de maille (plusieurs pour cents) ne peut pas être réalisée avec une qualité qui éviterait la dégradation de leurs caractéristiques électriques et optiques à cause de la présence de défauts structuraux. Dans un autre domaine, il est évident que l'on ne peut pas, avec les procédés de la microélectronique, réaliser des composants sur des supports plastiques d'abord parce que ces derniers ne résistent pas aux températures utilisées et ensuite parce qu'ils ne sont pas, par nature, compatibles avec les critères de propretés des étapes d'entrée ("front-end" en anglais) de l'industrie des semi-conducteurs.

De plus, l'invention permet d'associer un composant mince sur un support en utilisant une solidarisation par adhésion moléculaire qui est compatible "front end". Cela permet de traiter le composant après report avec des procédés dont par exemple les températures peuvent être élevées. Ainsi, par exemple, on peut reprendre une épitaxie ou réaliser les connexions entre le composant et le support.

Le report de vignettes permet aussi de s'affranchir des différences de diamètre entre les substrats sur lesquels sont réalisés les composants. Cela permet en particulier de limiter la perte de matériaux de départ comparé à un report pleine plaque où seules certaines zones transférées seront utilisées pour réaliser des composants.

Un autre avantage de transférer des vignettes de composants fabriqués est de pouvoir reporter un circuit testé électriquement et donc de ne reporter que les bons composants.

En outre, le report de composants amincis présente l'avantage de réduire l'encombrement vertical, de diminuer le poids de ces composants et de plus de les rendre moins fragiles. Mais le report de couches minces ou films est rendu difficile par leur petite taille qui les rend difficilement manipulables. Pour faciliter cette manipulation, il est avantageux d'utiliser un support de transfert qui sert de rigidificateur pour la manipulation de ces films et pour éviter que ceux-ci ne se déforment sous l'effet de contraintes, voire ne se cassent. Par rigidificateur, on entend tout support organique ou minéral dont la rigidité évite la rupture de zones prédécoupées, permet le maintien de l'ensemble des puces et évite des cassures et/ou fractures et/ou ruptures des vignettes et éléments à transférer. Ce rigidificateur peut être par exemple une plaque de silicium monocristallin (001) avec une épaisseur d'au moins 200 µm. Il peut aussi être en verre ou en un autre matériau transparent par exemple dans le visible, l'infrarouge ou l'ultraviolet. Cela, en particulier, rend possible l'alignement de la puce sur le support. Cela autorise aussi le traitement de la couche d'adhésion (par exemple : colle durcissable aux ultra-violets).

Le document FR-A-2781925 divulgue une méthode de report sélective de vignettes depuis un support initial vers un support final, utilisant un support de transfert.

Le rigidificateur utilisé pour reporter les vignettes peut être un support couramment utilisé en microélectronique (substrats monocristallins ou polycristallins, verres, etc.) ou d'autres supports tels que des films plastiques sensibles aux ultra-violets, des films double-face, des films étirables, des films en Teflon®, etc. Il peut s'agir d'une combinaison de ces différents supports permettant d'utiliser au mieux les propriétés de chacun d'eux.

Le rigidificateur doit pouvoir manipuler l'ensemble des puces à transférer lors des étapes collectives. Il doit aussi pouvoir libérer de façon sélective un élément parmi tous ceux préparés. Pour cela, une prédécoupe est effectuée selon l'épaisseur totale des couches d'éléments à transférer et selon une partie de l'épaisseur du rigidificateur. Ainsi, une zone maintenant l'intégralité de l'ensemble est conservée et il est possible de séparer sélectivement les éléments à transférer par apport local par exemple d'énergie mécanique et/ou thermique et/ou chimique.

L'invention a aussi pour objectif de fournir un procédé de transfert de composants à faible coût.

L'invention a pour objet un procédé de transfert sélectif de vignettes d'un support initial vers un support final, chaque vignette comprenant au moins un élément constitutif d'un dispositif microélectronique et/ou optoélectronique et/ou acoustique et/ou mécanique, les éléments étant réalisés dans une couche de surface du support initial, le procédé comprenant les étapes suivantes :
a) la fixation d'un support de transfert sur la couche de surface du support initial,
b) l'élimination de la partie du support initial ne correspondant pas à la couche de surface,
c) définition latérale des vignettes, sur l'ensemble constitué par le support de transfert et la couche de surfacé, par découpe effectuée selon l'épaisseur de la couche de surface,
d) préhension d'une ou de plusieurs vignettes à transférer et leur détachement par apport d'énergie dans les zones dudit ensemble,
e) report et fixation sur le support final de la vignette ou de la pluralité de vignettes détachées à l'étape d),
caractérisé en ce que :
dans l'étape c), la découpe est effectuée selon l'épaisseur totale de la couche de surface et selon une partie de l'épaisseur du support de transfert de façon à laisser subsister des zones dudit ensemble pouvant être rompues et,
dans l'étape d), l'apport d'énergie conduit à la rupture desdites zones dudit ensemble.

Par élément constitutif, il faut entendre au moins une couche d'un matériau pouvant être traité avant ou après transfert ou être utilisé en tant que tel. Le matériau peut être choisi parmi les matériaux semi-conducteurs (Si, SiC, GaAs, InP, GaN, HgCdTe), les matériaux piézoélectriques (LiNbO₃, LiTaO₃), pyroélectriques, ferroélectriques, magnétiques et même isolants.

Si la couche de surface comprend en outre une couche d'adhésion recouvrant lesdits éléments, l'étape a) peut comprendre la fixation du support de transfert sur la couche d'adhésion. La couche d'adhésion peut être un film adhésif double face ou en un matériau choisi parmi une colle, par exemple de type polymère (par exemple polyimide, BCB, résine de type époxy ou photosensible.), une cire, de l'oxyde de silicium (par exemple de type SOG ou PECVD ou thermique) et du silicium. Si elle recouvre les éléments, elle peut être une couche déposée et polie.

A l'étape a), la fixation peut être réalisée par adhésion moléculaire, cette adhésion moléculaire pouvant être renforcée par un traitement thermique.

A l'étape b), l'élimination de la partie du support initial ne correspondant pas à la couche de surface peut être réalisée par une ou plusieurs méthodes choisies parmi : la rectification mécanique, le polissage, l'attaque chimique sèche ou humide, la fracture le long d'une couche fragilisée.

A l'étape c), la découpe peut être effectuée par gravure chimique sèche ou humide, par sciage, par ultrasons, par clivage ou par un faisceau laser.

A l'étape d), la préhension est réalisée par des moyens mécaniques, de capillarité, des moyens électrostatiques ou de préférence des moyens pneumatiques (par exemple par aspiration) et/ou chimiques.

A l'étape d), l'apport d'énergie peut être un apport d'énergie mécanique et/ou thermique et/ou chimique. Le détachement peut être réalisé en combinant des effets de pression et d'aspiration sur la ou les vignettes à transférer.

Avantageusement, à l'étape e), la fixation est obtenue par adhésion moléculaire ou par collage. Le collage peut se faire au moyen d'une colle, d'une résine époxy ou d'une couche métallique réactive ou non.

Après l'étape e), la partie du support de transfert correspondant à la vignette reportée ou à la pluralité de vignettes reportées peut être éliminée au moins partiellement. Cette élimination peut être réalisée par une ou plusieurs méthodes choisies parmi : la technique du "lift-off", l'attaque chimique ou l'attaque sélective de la couche d'adhésion, l'application de forces mécaniques et la fracture le long d'une couche fragilisée. La couche fragilisée est obtenue par exemple par création de microcavités et/ou de microbulles gazeuses obtenues par implantation ionique ou par exemple par la présence d'une couche enterrée poreuse ou par tout autre moyen qui permet de séparer la couche de surface du support initial.

Eventuellement, avant l'étape c), on ajoute au support de transfert des moyens permettant de le garder rigide pendant l'étape c). Après l'étape c), les moyens permettant de rigidifier le support de transfert peuvent être éliminés au moins partiellement.

Ces moyens peuvent être déformables mécaniquement, la déformation produite favorisant la rupture des zones pouvant être rompues. Ces moyens peuvent aussi être des films plastiques.

La couche de surface peut comprendre au moins une couche d'arrêt adjacente à la partie du support initial ne correspondant pas à la couche de surface. Cette couche d'arrêt peut également être éliminée.

Avant l'étape a), ledit élément constitutif d'un dispositif microélectronique et/ou opto-électronique et/ou acoustique et/ou mécanique peut être testé pour déterminer son état de fonctionnement.

A l'étape a), la fixation du support de transfert peut être obtenue par dépôt d'une couche de matériau sur la couche de surface, cette couche de matériau constituant le support de transfert.

A l'étape c), la découpe peut être effectuée à partir de la couche de surface et/ou à partir du support de transfert.

Avant la fixation sur le support final de la vignette ou de la pluralité de vignettes, une préparation de surface peut être effectuée pour améliorer la fixation (nettoyage, élimination d'une couche sacrificielle, polissage, .). Lors de la fixation sur le support final, la vignette peut être en outre alignée sur ce support en utilisant soit des marques préétablies sur vignette et support, soit de préférence un support de transfert en un matériau transparent.

Après l'étape e), il peut être prévu une étape permettant de révéler ledit élément constitutif d'un dispositif microélectronique actif ou passif et/ou opto-électronique et/ou d'un capteur.

Si le support initial est du type SOI, c'est-à-dire constitué d'un substrat de silicium supportant successivement une couche d'oxyde de silicium et une couche de silicium dans laquelle est réalisé ledit élément, la couche d'oxyde de silicium sert de couche d'arrêt.

### BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- les figure 1A à 1J sont des vues en coupe transversale illustrant un premier exemple de mise en oeuvre du procédé de transfert sélectif selon l'invention,
- les figures 2A à 2I sont des vues en coupe transversale illustrant un deuxième exemple de mise en oeuvre du procédé de transfert sélectif selon l'invention,
- les figures 3A à 3E sont des vues en coupe transversale illustrant un troisième exemple de mise en oeuvre du procédé de transfert sélectif selon l'invention.

### DESCRIPTION DETAILLEE DE MODES DE REALISATION DE L'INVENTION

D'une manière générale, le procédé s'applique à des éléments réalisés totalement ou partiellement sur des substrats par les techniques de la microélectronique et/ou de l'optoélectronique. Les éléments peuvent éventuellement être réalisés sur une ou plusieurs couches d'arrêt chimique. Ils peuvent éventuellement subir un test électrique sur leur support initial.

Dans le cas où une forte topologie de surface est présente, un lissage de la surface peut être réalisé par dépôt d'un matériau puis polissage mécano-chimique ou par remplissage des volumes par un matériau suffisamment lisse qui ne nécessite pas forcément de polissage ultérieur. Si la couche de matériau de remplissage est suffisamment épaisse et rigide, elle peut aussi assurer une fonction de rigidification et constituer le support de transfert. Par ailleurs, elle peut, le cas échéant, assurer une fonction d'adhésion.

Différentes techniques peuvent être utilisées pour fixer le support de transfert sur le support initial : adhésion moléculaire, colle, résine époxy, etc. L'adhésion moléculaire est particulièrement appropriée lorsque les surfaces à mettre en contact sont lisses. Une couche d'adhésion peut être utile pour fixer la couche de surface sur le support de transfert. Elle peut être en un matériau choisi parmi un film adhésif double face, de la colle par exemple de type polymère (polyimide, BCB, résine de type époxy ou photosensible.), de la cire, du verre, de l'oxyde de silicium de type "spin on glass", déposé ou thermique.

La préhension des vignettes peut se faire par une technique classique de "pick and place" ou toute autre technique par laquelle la vignette est tenue et une énergie est amenée localement pour provoquer la rupture de la vignette à transférer. De façon avantageuse, la vignette est manipulée avec un outil permettant de l'aspirer tout en exerçant une pression pour la séparer des autres vignettes. L'outil permet alors de reporter la vignette détachée sur le support final.

De préférence, le support de transfert est un substrat utilisé en microélectronique et de faible coût, par exemple du silicium monocristallin ou polycristallin, du verre, du saphir, ..

Les éléments peuvent être réalisés sur un support initial comprenant plusieurs couches d'arrêt. L'utilisation de plusieurs couches d'arrêt est avantageuse pour lisser la surface résultant d'une attaque chimique du support initial. L'utilisation de plusieurs couches d'arrêt peut aussi permettre d'enlever les particules résultant de la fragilisation verticale des vignettes à transférer et éventuellement du support de transfert.

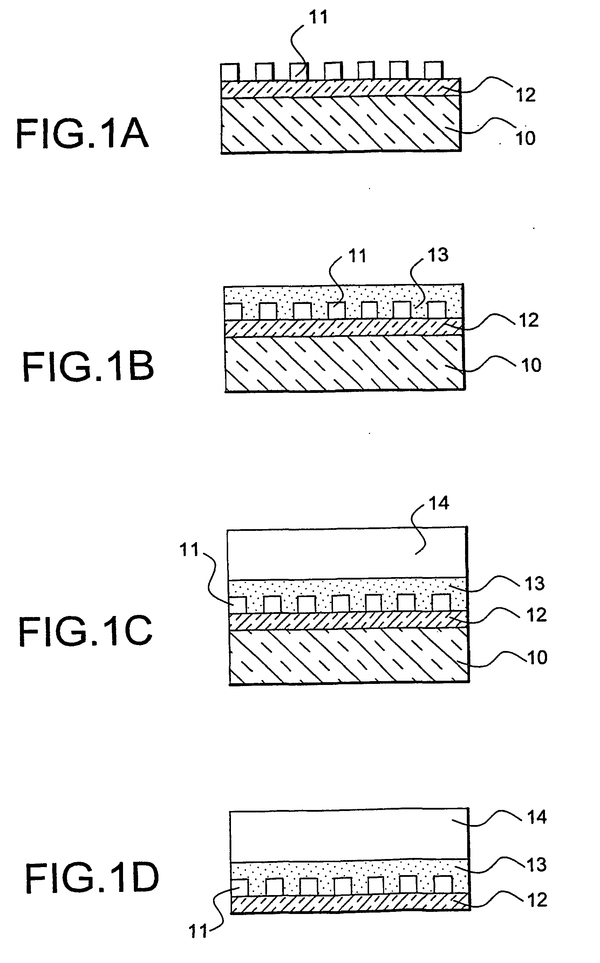

Un premier exemple de mise en oeuvre de l'invention est illustré par les figures 1A à 1J qui sont des vues partielles et en coupe.

La figure 1A montre un substrat 10, par exemple en GaAs, servant de support initial et sur lequel ont été réalisées des puces semiconductrices 11 (par exemple : composants optoélectroniques ou microélectroniques) selon les techniques connues de l'homme de l'art. Les puces 11 sont séparées du reste du support initial par au moins une couche d'arrêt 12 par exemple en AlₓGa₍₁₋ₓ₎As. Cette couche d'arrêt procure une meilleure homogénéité du transfert car elle constitue une couche d'arrêt et une couche sacrificielle par exemple vis-à-vis d'une gravure chimique sèche ou humide.

Comme le montre la figure 1B, la surface du substrat 10 comportant les puces 11 est lissée pour permettre un collage sur un support de transfert. Cette opération peut être obtenue par le dépôt ou l'étalement d'une couche 13 qui peut être une colle, une résine époxy ou un matériau minéral tel qu'un verre, de la silice ou du silicium. Une planarisation de la couche 13 peut éventuellement être nécessaire. La couche d'arrêt 12, les éléments ou puces semiconductrices 11 et la couche 13 constituent la couche de surface du support initial.

A la figure 1C, un support de transfert 14 est collé sur la face libre de la couche 13. Si la couche 13 est une couche de résine époxy, celle-ci est ensuite polymérisée. Si la couche 13 est une couche minérale, un traitement thermique permet d'augmenter l'énergie d'adhésion au support de transfert 14.

La figure 1D montre que le support initial 10, plus exactement la partie du support initial qui ne correspond pas à la couche de surface, a été éliminé. Cette élimination peut se faire par une méthode classique ou une combinaison de méthodes classiques : rectification mécanique, polissage, attaque chimique sèche ou humide. Le substrat a pu être fragilisé en profondeur par implantation ionique d'ions ou d'espèces gazeuses avant d'avoir réalisé le composant. La séparation de la couche mince du substrat peut alors être obtenue par apport d'énergie mécanique (voir le document FR-A-2 748 851).

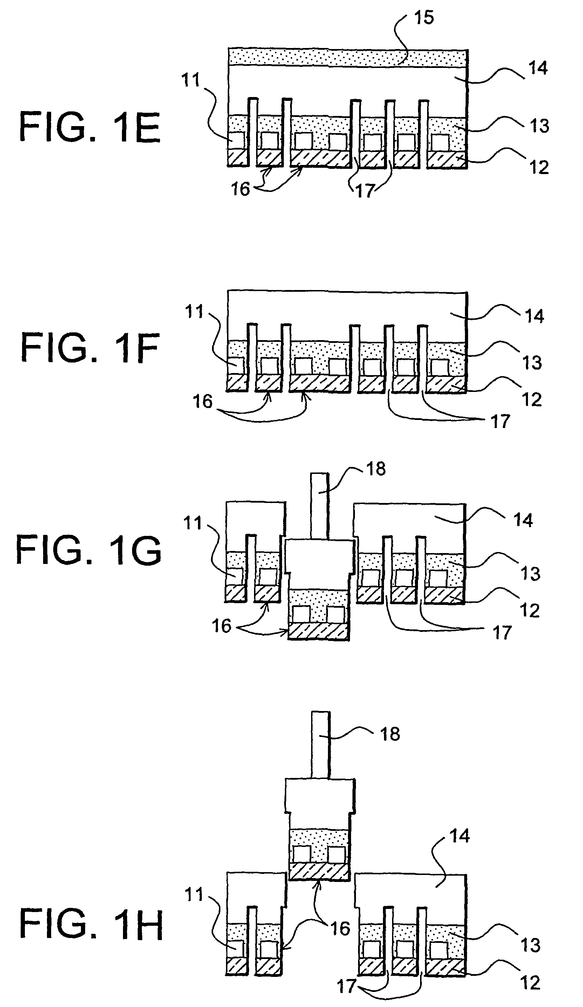

Comme le montre la figure 1E, une pièce de rigidification 15 est fixée sur la face libre du support de transfert 14. Cette pièce 15 peut être un support de découpe. Les vignettes à transférer sont ensuite prédécoupées verticalement par des tranchées 17. Une vignette 16 à transférer comprend au moins une puce 11. La prédécoupe des vignettes est effectuée totalement dans les couches 12 et 13 mais partiellement dans le support de transfert 14. La prédécoupe laisse subsister des zones pouvant être rompues dans le support de transfert 14. Cette prédécoupe peut être faite par gravure chimique, au moyen d'une scie circulaire, d'une scie à disque, d'une scie à fil ou au moyen d'ultrasons. Suivant l'application, le dispositif peut être terminé avant ou après report sur le support final.

La face libre de la couche d'arrêt 12 est traitée chimiquement pour éliminer les particules et les contaminants qui ont pu apparaître lors des opérations précédentes et qui rendraient cette face impropre à l'adhésion moléculaire. Si plusieurs couches d'arrêt ont été prévues, une ou plusieurs de ces couches peut être enlevée chimiquement en voie sèche ou en voie humide ou même par polissage mécano-chimique pour éliminer simultanément les polluants présents en surface. De plus, comme la pièce de rigidification 15 (voir la figure 1E) n'est pas forcément compatible avec les traitements chimiques que doit subir une surface pour permettre son adhésion moléculaire, la pièce 15 peut être éliminée juste après la réalisation des tranchées 17 comme le montre la figure 1F.

Les vignettes 16 à reporter sont alors prises sélectivement (voir les figures 1G et 1H), les zones de rupture se rompant sous pression, ou sous aspiration, ou sous un enchaînement de pression et d'aspiration, ou sous un enchaînement de pression et de relâchement de pression, ou sous un enchaînement d'aspiration et de relâchement d'aspiration. Préférentiellement, la rupture est réalisée par une pression brutale d'un outil 18 permettant de manipuler la vignette à transférer, par exemple une pince à vide qui aura été adaptée aux dimensions des puces.

La vignette 16 prélevée est ensuite fixée sur un support final 19 par adhésion moléculaire comme le montre la figure 1I. Le support final 19 peut avoir subi des préparations de surface de la microélectronique pour permettre l'adhésion moléculaire de la vignette 16 par exemple un nettoyage chimique de type hydrophile ou un polissage mécano-chimique.

Le matériau de la couche 13 est ensuite éliminé par sous-gravure, de qui a pour conséquence de séparer la partie du support de transfert transférée avec le reste de la vignette. Cette partie du support de transfert peut aussi être enlevée par cisaillement, le matériau de la couche 13 pouvant être alors éliminé par attaque chimique. On obtient la structure montrée à la figure 1J.

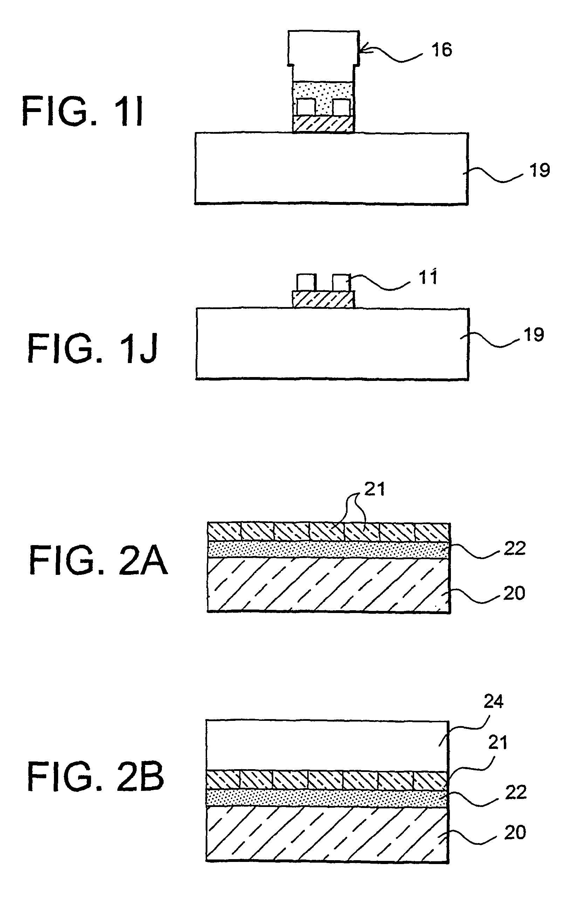

Un deuxième exemple de mise en oeuvre de l'invention est illustré par les figures 2A à 2I qui sont des vues partielles et en coupe.

La figure 2A montre un substrat 20 servant de support initial. Le substrat 20 est un substrat SOI comprenant une couche de silice 22, servant de couche d'arrêt chimique, et une couche mince de silicium dans laquelle ont été réalisées des puces semiconductrices 21 selon les techniques connues de l'homme de l'art. La couche de silice 22 et la couche mince de silicium constituent la couche de surface du support initial.

Dans cet exemple, les puces 21 (par exemple : dispositifs microélectroniques, circuits d'adressage de transistors TFT, .) sont destinées à être transférées de manière sélective. La surface libre des puces 21 est alors rendue solidaire d'un support de transfert 24 comme le montre la figure 2B. Le support de transfert 24 est collé sur la surface libre des puces 21 sans la présence d'une couche supplémentaire.

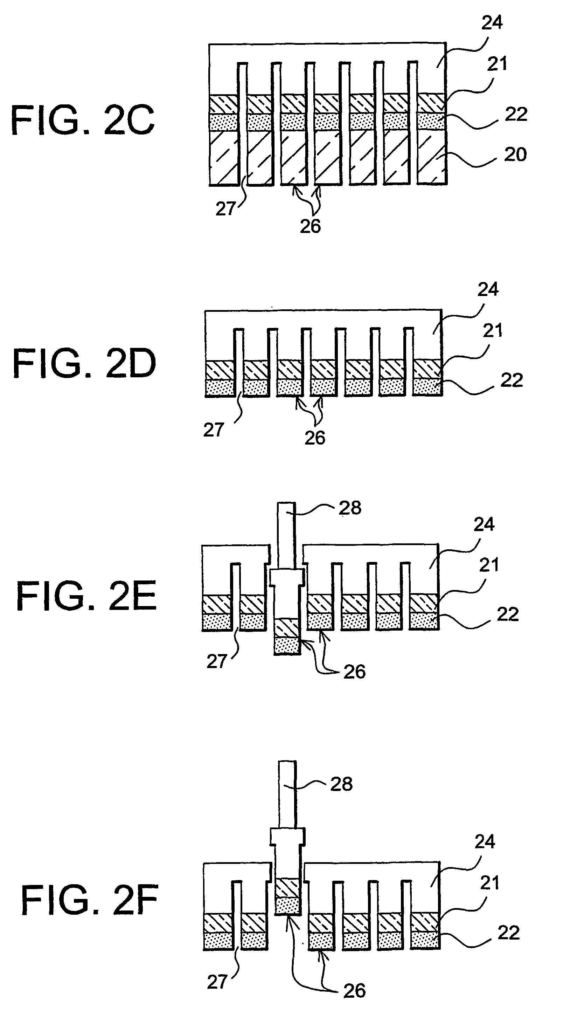

Par une méthode de découpe choisie parmi la découpe mécanique, la découpe par laser, le clivage partiel, la réalisation de défauts, d'amorces de clivage, des tranchées 27 sont réalisées dans le support initial 20, y compris la couche de silice 22 et la couche mince, et partiellement dans le support de transfert 24 pour y laisser subsister des zones de rupture. Les tranchées 27 délimitent des vignettes 26, chaque vignette comportant une puce. C'est ce que montre la figure 2C.

La partie massive du support initial 20 est ensuite éliminée comme le montre la figure 2D. Cette élimination peut être effectuée par une méthode classique ou une combinaison de méthodes classiques. On peut citer, à titre d'exemples, la rectification mécanique, le polissage, l'attaque chimique sèche ou humide. Dans ce deuxième exemple de mise en oeuvre, la rectification peut être utilisée seule car la face de report de chaque vignette n'a pas besoin d'être lisse pour être collée.

Les vignettes 26 à reporter sont prises sélectivement (voir les figures 2E et 2F), les zones de rupture se rompant par l'une des méthodes citées dans le premier exemple de mise en oeuvre. De préférence, la rupture est réalisée par une pression d'un outil 28 permettant de manipuler la vignette à transférer, par exemple une pince à vide.

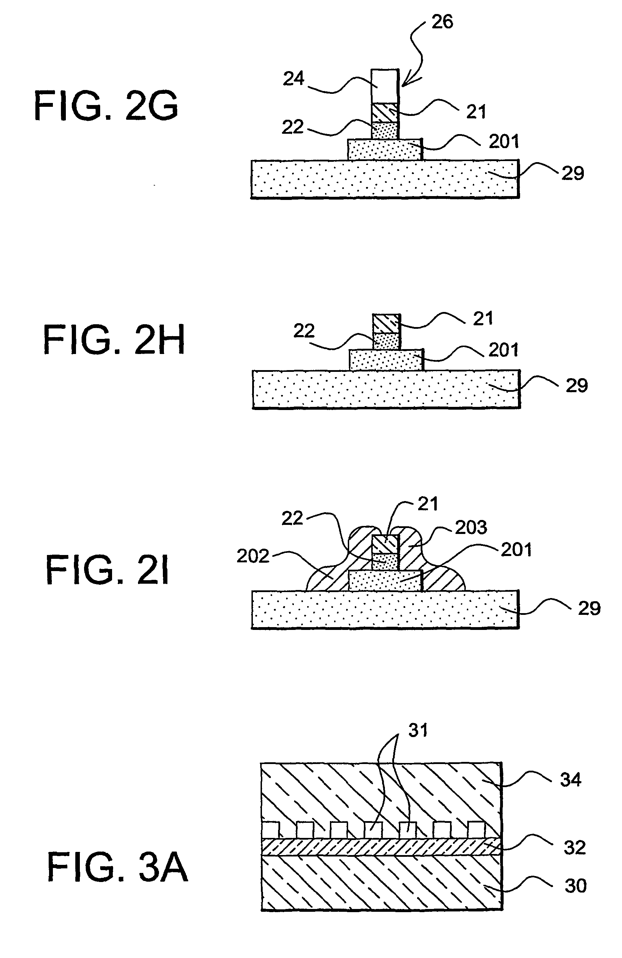

La vignette 26 prélevée est ensuite collée sur un support de réception ou support final 29 par l'intermédiaire d'un plot de colle 201. C'est ce que montre la figure 2G. Le support final 29 peut être un matériau organique. Il peut s'agir d'une carte destinée à recevoir un circuit électronique pour réaliser une carte à puce. On peut choisir la colle pour qu'elle puisse être éliminée à l'aide d'un solvant (par exemple une cire commerciale et de l'acétone).

La partie du support de transfert 24 encore présente avec la puce 21 reportée sur le support final 29 peut être éliminée par l'une des méthodes citées dans le premier exemple de mise en oeuvre. On obtient la structure montrée à la figure 2H.

Un complément technologique peut ensuite être réalisé sur la puce 21 reportée comme le montre la figure 2I, par exemple en réalisant des contacts métalliques 202 et 203 par une technique connue de la microélectronique.

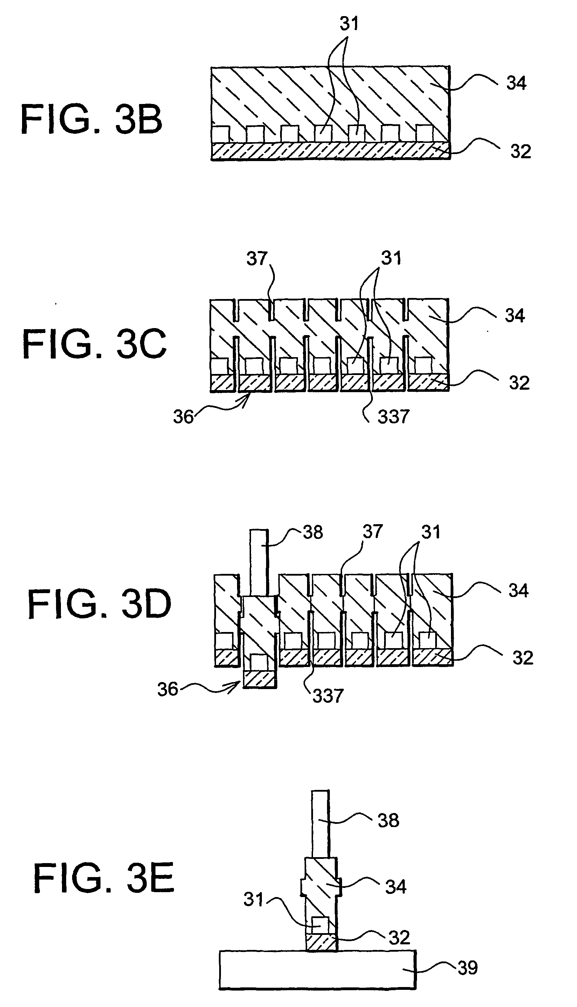

Un troisième exemple de mise en oeuvre de l'invention est illustré par les figures 3A à 3E qui sont des vues partielles et en coupe.

La figure 3A montre un substrat 30 servant de support initial. Il peut s'agir d'un substrat de GaAs sur lequel ont été réalisées des puces semiconductrices selon des techniques connues de l'homme de l'art. Au moins une couche d'arrêt 32, par exemple en AlₓGa₍₁₋ₓ₎As, sépare les puces semiconductrices du substrat 30. Cette couche d'arrêt (ou ces couches d'arrêt éventuellement) procure l'avantage d'une meilleure homogénéité du transfert car elle constitue une couche d'arrêt et une couche sacrificielle, par exemple vis-à-vis d'une gravure chimique sèche ou humide.

Les puces semiconductrices, dans cet exemple de réalisation, sont constituées par des éléments de base 31 et des éléments complémentaires regroupés sous la référence générale 34. On peut donc dire que la couche d'arrêt 32 et les éléments de base 31 constituent la couche de surface du support initial tandis que l'ensemble 34 des éléments complémentaires sert de support de transfert.

La figure 3B montre que le support initial a été éliminé par une méthode classique ou une combinaison de méthodes classiques. On peut citer par exemple la rectification mécanique, le polissage, l'attaque chimique sèche ou humide.

Les vignettes à reporter sont ensuite prédécoupées par l'une des méthodes citées dans les exemples précédents. La figure 3C montre que les découpes ont été effectuées à partir de chaque face libre de la structure. Des tranchées 37 et 337, respectivement alignées, délimitent des vignettes 36 comprenant un ou plusieurs éléments de base 31. Il subsiste une zone de rupture entre chaque alignement de tranchées 37 et 337.

Les vignettes 36 à reporter sont prises sélectivement (voir la figure 3D), les zones de rupture se rompant par l'une des méthodes citées dans le premier exemple de mise en oeuvre. De préférence, la rupture est réalisée par une pression brutale d'un outil 38 permettant de manipuler la vignette à transférer, par exemple une pince à vide.

La vignette 36 prélevée est ensuite collée sur un support de réception ou support final 39 par adhésion moléculaire et l'outil 38 est retiré. C'est ce que montre la figure 3E. Le support final 39 peut avoir subi des préparations de surface de la microélectronique pour améliorer l'adhésion moléculaire de la vignette 36 sur ce support.

## Revendications

1. Procédé de transfert sélectif de vignettes (16, 26, 36) d'un support initial (10, 20, 30) vers un support final (19, 29, 39), chaque vignette comprenant au moins un élément (11, 21, 31) constitutif d'un dispositif microélectronique et/ou optoélectronique et/ou acoustique et/ou mécanique, les éléments étant réalisés dans une couche de surface du support initial, le procédé comprenant les étapes suivantes :
a) la fixation d'un support de transfert (14, 24, 34) sur la couche de surface (12,11,13;22,21;32,31) du support initial (10, 20, 30),
b) l'élimination de la partie du support initial ne correspondant pas à la couche de surface,
c) définition latérale des vignettes, sur l'ensemble constitué par le support de transfert et la couche de surface, par découpe effectuée selon l'épaisseur de la couche de surface,
d) préhension d'une ou de plusieurs vignettes (16, 26, 36) à transférer et leur détachement par apport d'énergie dans les zones dudit ensemble,
e) report et fixation sur le support final (19, 29, 39) de la vignette ou de la pluralité de vignettes détachées à l'étape d),
**caractérisé en ce que**:
dans l'étape c), la découpe est effectuée selon l'épaisseur totale de la couche de surface et selon une partie de l'épaisseur du support de transfert de façon à laisser subsister des zones dudit ensemble pouvant être rompues, et,
dans l'étape d), l'apport d'énergie conduit à la rupture desdites zones dudit ensemble.

2. Procédé selon la revendication 1, **caractérisé en ce que**, la couche de surface comprenant en outre une couche d'adhésion (13) recouvrant lesdits éléments, (11) l'étape a) comprend la fixation du support de transfert (14) sur la couche d'adhésion (13).

3. Procédé selon la revendication 2, **caractérisé en ce que** la couche d'adhésion (13) est un film adhésif double face ou en un matériau choisi parmi une colle, une cire, de l'oxyde de silicium et du silicium.

4. Procédé selon la revendication 3, **caractérisé en ce que** la colle est une colle choisie parmi un polyimide, du BCB et une résine de type époxy ou photosensible.

5. Procédé selon la revendication 2, **caractérisé en ce que** la couche d'adhésion (13) recouvrant lesdits éléments (11) est une couche déposée et polie.

6. Procédé selon la revendication 1, **caractérisé en ce que**, à l'étape a), la fixation est réalisée par adhésion moléculaire.

7. Procédé selon la revendication 6, **caractérisé en ce que** la fixation par adhésion moléculaire est renforcée par un traitement thermique.

8. Procédé selon la revendication 1, **caractérisé en ce que**, à l'étape b), l'élimination de la partie du support initial (10, 20, 30) ne correspondant pas à la couche de surface est réalisée par une ou plusieurs méthodes choisies parmi : la rectification mécanique, le polissage, l'attaque chimique sèche ou humide, la fracture le long d'une couche fragilisée.

9. Procédé selon la revendication 1, **caractérisé en ce que**, à l'étape c), la découpe est effectuée par gravure chimique sèche ou humide, par sciage, par ultrasons, par clivage ou par un faisceau laser.

10. Procédé selon la revendication 1, **caractérisé en ce que**, à l'étape d), la préhension est réalisée par une technique impliquant des moyens mécaniques, de capillarité, des moyens électrostatiques, des moyens pneumatiques et/ou chimiques.

11. Procédé selon la revendication 1, **caractérisé en ce que**, à l'étape d), l'apport d'énergie est un apport d'énergie mécanique et/ou thermique et/ou chimique.

12. Procédé selon la revendication 1, **caractérisé en ce que**, à l'étape d), le détachement est réalisé en combinant des effets de pression et d'aspiration sur la ou les vignettes (16, 26, 36) à transférer.

13. Procédé selon la revendication 1, **caractérisé en ce que**, à l'étape e), la fixation est obtenue par adhésion moléculaire ou par collage.

14. Procédé selon la revendication 13, **caractérisé en ce que**, à l'étape e) la fixation est obtenue par collage au moyen d'une colle, d'une résine époxy ou d'une couche métallique réactive ou non.

15. Procédé selon la revendication 1, **caractérisé en ce que**, après l'étape e), la partie du support de transfert (14, 24) correspondant à la vignette reportée (16, 26) ou à la pluralité de vignettes reportées est éliminée au moins partiellement.

16. Procédé selon la revendication 15, **caractérisé en ce que** ladite élimination au moins partielle de la partie du support de transfert (16, 26) est réalisée par une ou plusieurs méthodes choisies parmi : la technique du "lift-off", l'attaque chimique ou l'attaque sélective de la couche d'adhésion, l'application de forces mécaniques et la fracture le long d'une couche fragilisée.

17. Procédé selon la revendication 1, **caractérisé en ce que**, avant l'étape c), on ajoute au support de transfert (14) des moyens (15) permettant de le garder rigide pendant l'étape c).

18. Procédé selon la revendication 17, **caractérisé en ce que**, après l'étape c), les moyens (15) permettant de rigidifier le support de transfert (14) sont éliminés au moins partiellement.

19. Procédé selon la revendication 1, **caractérisé en ce que** la couche de surface comprend au moins une couche d'arrêt (12, 22, 32) adjacente à la partie du support initial (10, 20, 30) ne correspondant pas à la couche de surface.

20. Procédé selon la revendication 19, **caractérisé en ce que** la couche d'arrêt est également éliminée.

21. Procédé selon la revendication 1, **caractérisé en ce que**, avant l'étape a), ledit élément (11, 21, 31) constitutif d'un dispositif microélectronique et/ou optoélectronique et/ou acoustique et/ou mécanique est testé pour déterminer son état de fonctionnement.

22. Procédé selon la revendication 1, **caractérisé en ce que**, à l'étape a), la fixation du support de transfert est obtenue par dépôt d'une couche de matériau sur la couche de surface, cette couche de matériau constituant le support de transfert.

23. Procédé selon la revendication 1, **caractérisé en ce que**, à l'étape c), la découpe est effectuée à partir de la couche de surface et/ou à partir du support de transfert.

24. Procédé selon la revendication 1, **caractérisé en ce que**, avant la fixation sur le support final de la vignette (16, 26, 36) ou de la pluralité de vignettes, une préparation de surface est effectuée pour améliorer la fixation.

25. Procédé selon la revendication 1, **caractérisé en ce que**, après l'étape e), il est prévu une étape permettant de révéler ledit élément (11, 21) constitutif d'un dispositif microélectronique actif ou passif et/ou optoélectronique et/ou d'un capteur.

26. Procédé selon la revendication 1, **caractérisé en ce que**, le support initial (20) étant du type SOI, c'est-à-dire constitué d'un substrat de silicium supportant successivement une couche d'oxyde (22) de silicium et une couche de silicium dans laquelle est réalisé ledit élément (21), la couche d'oxyde de silicium sert de couche d'arrêt.

27. Procédé selon la revendication 1, **caractérisé en ce que**, lors de sa fixation sur le support final, la vignette est alignée sur ce support final en utilisant des marques préétablies sur vignette et support final ou en utilisant un support de transfert en matériau transparent.

## Patentansprüche

1. Verfahren für den selektiven Transfer von vignettenartigen Bauteilen bzw. Chips (16, 26, 36) von einem Anfangsträger (10, 20, 30) zu einem Endträger (19, 29, 39), wobei jeder Chip wenigstens ein wesentliches Element (11, 21, 31) einer mikroelektronischen und/oder optoelektronischen und/oder akustischen und/oder mechanischen Vorrichtung umfasst, die Elemente in einer Oberflächenschicht des Anfangsträgers realisiert sind, das Verfahren die folgenden Schritte umfasst:
a) Befestigen eines Transferträgers (14, 24, 34) an der Oberflächenschicht (12, 11, 13; 22, 21; 32, 31) des Anfangsträgers (10, 20, 30),
b) Eliminieren des nicht der Oberflächenschicht entsprechenden Teils des Anfangsträgers,
c) Definieren der Seiten der Vignetten bzw. Chips bei dem durch den Transferträger und die Oberflächenschicht gebildeten Aufbau, indem man die Oberflächenschicht in der Richtung ihrer Dicke durchtrennt,
d) Greifen eines oder mehrerer für den Transfer vorgesehener Vignetten bzw. Chips (16, 26, 36) und Loslösen durch Energiezufuhr in den Zonen des genannten Aufbaus,
e) Anbringen und Befestigen des bzw. der in Schritt d) losgelösten Chips auf dem Endträger (19, 29, 39),
**dadurch gekennzeichnet,**
**dass** in Schritt c) das Durchtrennen der Oberflächenschicht über deren gesamte Dicke und über einen Teil der Dicke des Transferträgers erfolgt, um in dem genannten Aufbau Zonen zu realisieren, die gebrochen werden können, und
**dass** in Schritt d) die Energiezufuhr zum Brechen der genannten Zonen des genannten Aufbaus führt.

2. Verfahren nach Anspruch 1, **dadurch gekennzeichnet, dass** die Oberflächenschicht außerdem eine Haftschicht (13) umfasst, welche die genannten Elemente (11) bedeckt, und der Schritt a) die Befestigung des Transferträgers (14) auf der Haftschicht (13) umfasst.

3. Verfahren nach Anspruch 2, **dadurch gekennzeichnet, dass** die Haftschicht (13) ein doppelseitiger Haftfilm oder ein unter Klebstoff, Wachs, Siliciumoxid und Silicium ausgewählter Stoff ist.

4. Verfahren nach Anspruch 3, **dadurch gekennzeichnet, dass** der Klebstoff ein unter einem Polyimid, BCB und einem Harz des Typs Epoxyd oder Photoresist ausgewählter Klebstoff ist.

5. Verfahren nach Anspruch 2, **dadurch gekennzeichnet, dass** die die genannten Elemente (11) bedeckende Haftschicht (13) eine abgeschiedene und polierte Schicht ist.

6. Verfahren nach Anspruch 1, **dadurch gekennzeichnet, dass** in dem Schritt a) die Befestigung durch Molekularadhäsion realisiert wird.

7. Verfahren nach Anspruch 6, **dadurch gekennzeichnet, dass** die Befestigung durch Molekularadhasion mittels einer thermischen Behandlung verstärkt wird.

8. Verfahren nach Anspruch 1, **dadurch gekennzeichnet, dass** in dem Schritt b) die Eliminierung des nicht der Oberflächenschicht entsprechenden Teils des Anfangsträgers (10, 20, 30) mittels eines oder mehrerer Verfahren erfolgt, die ausgewählt werden unter dem mechanischen Schleifen, dem Polieren, einem trocken- oder nasschemischen Ätzen, einem Brechen längs einer geschwächten Schicht.

9. Verfahren nach Anspruch 1, **dadurch gekennzeichnet, dass** in dem Schritt c) das Durchtrennen durch trocken- oder nasschemisches Ätzen, durch Sägen, durch Ultraschall, durch Spalten oder durch einen Laserstrahl erfolgt.

10. Verfahren nach Anspruch 1, **dadurch gekennzeichnet, dass** das Greifen durch eine Technik erfolgt, die mechanische Einrichtungen, Kapillarwirkung, elektrostatische Einrichtungen, pneumatische und/oder chemische Mittel umfasst.

11. Verfahren nach Anspruch 1, **dadurch gekennzeichnet, dass** in dem Schritt d) die Energiezufuhr eine Zuführung mechanischer und/oder thermischer und/oder chemischer Energie ist.

12. Verfahren nach Anspruch 1, **dadurch gekennzeichnet, dass** in dem Schritt d) das Loslösen realisiert wird, indem man die auf den oder die Chips (16, 26, 36) ausgeübten Druck- und Saugeffekte kombiniert.

13. Verfahren nach Anspruch 1, **dadurch gekennzeichnet, dass** in dem Schritt e) die Befestigung durch Molekularadhäsion oder durch Kleben realisiert wird.

14. Verfahren nach Anspruch 13, **dadurch gekennzeichnet, dass** in dem Schritt e) die Befestigung durch Kleben mittels eines Klebstoffs, eines Epoxidharzes oder einer metallischen Schicht realisiert wird, die reaktiv ist oder nicht.

15. Verfahren nach Anspruch 1, **dadurch gekennzeichnet, dass** nach dem Schritt e) der Teil des Transferträgers (14, 24), der dem übertragenen Chip (16, 26) oder der Vielzahl übertragener Chips entspricht (16, 26), wenigstens partiell eliminiert wird.

16. Verfahren nach Anspruch 15, **dadurch gekennzeichnet, dass** das genannte wenigstens partielle Eliminieren des Teils des Transferträgers (16, 26) durch ein oder mehrere Verfahren realisiert wird, ausgewählt unter der Lift-off-Technik, dem chemischen Ätzen oder dem selektiven Ätzen der Adhäsionsschicht, dem Anwenden mechanischer Kräfte und dem Brechen längs einer geschwächten Schicht.

17. Verfahren nach Anspruch 1, **dadurch gekennzeichnet, dass** man vor dem Schritt c) dem Transferträger (14) Einrichtungen (15) hinzufügt, die ihn während des Schritts c) steif halten.

18. Verfahren nach Anspruch 17, **dadurch gekennzeichnet, dass** nach dem Schritt c) die Versteifungseinrichtungen (15) des Transferträgers wenigstens partiell eliminiert werden.

19. Verfahren nach Anspruch 1, **dadurch gekennzeichnet, dass** die Oberflächenschicht wenigstens eine Sperrschicht (12, 22, 32) umfasst, die an den Teil des Anfangsträgers (10, 20, 30) angrenzt, der nicht der Oberflächenschicht entspricht.

20. Verfahren nach Anspruch 19, **dadurch gekennzeichnet, dass** die Sperrschicht ebenfalls eliminiert wird.

21. Verfahren nach Anspruch 1, **dadurch gekennzeichnet, dass** vor dem Schritt a) das genannte wesentliche Element einer mikroelektronischen und/oder optoelektronischen und/oder akustischen und/oder mechanischen Vorrichtung getestet wird, um seinen Betriebsfähigkeitszustand festzustellen.

22. Verfahren nach Anspruch 1, **dadurch gekennzeichnet, dass** in dem Schritt a) das Befestigen des Transferträgers durch die Abscheidung einer Materialschicht auf der Oberflächenschicht realisiert wird, wobei diese Materialschicht den Transferträger bildet.

23. Verfahren nach Anspruch 1, **dadurch gekennzeichnet, dass** in dem Schritt c) das Durchtrennen ab der Oberflächenschicht und/oder ab dem Transferträger erfolgt.

24. Verfahren nach Anspruch 1, **dadurch gekennzeichnet, dass** vor der Befestigung des Chips (16, 26, 36) oder der Vielzahl von Chips auf dem Endträger eine Oberflächenvorbereitung durchgeführt wird, um die Befestigung zu verbessern.

25. Verfahren nach Anspruch 1, **dadurch gekennzeichnet, dass** nach dem Schritt e) ein Schritt vorgesehen ist, der ermöglicht, das genannte wesentliche Element (11, 21) einer aktiven oder passiven mikroelektronischen und/oder optoelektronischen Vorrichtung und/oder eines Sensors zu entnehmen.

26. Verfahren nach Anspruch 1, **dadurch gekennzeichnet, dass** der Anfangsträger (20) vom SOI-Typ ist, das heißt gebildet durch ein Siliciumsubstrat, das nacheinander eine Siliciumoxidschicht (22) und eine Siliciumschicht umfasst, in der das genannte Element (21) realisiert ist, wobei die Siliciumoxidschicht als Sperrschicht dient.

27. Verfahren nach Anspruch 1, **dadurch gekennzeichnet, dass** der Chip auf diesem Endträger mit Hilfe von Markierungen ausgerichtet wird, die vorher auf dem Chip und dem Endträger angebracht wurden, oder indem ein Transferträger aus transparentem Material benutzt wird.

## Claims

1. Process of selective transfer of labels (16, 26, 36) from an initial support (10, 20, 30) to a final support (19, 29, 39), with each label made up of at least one element (11, 21, 31) constituent of a microelectronic and/or optoelectronic and/or acoustic and/or mechanical device, the elements being made in a surface layer of the initial support, and the process including the following stages:
a) fixing a transfer support (14, 24, 34) on the surface layer (12, 11, 13; 22, 21; 32, 31) of the initial support (10, 20, 30);
b) removal of the part of the initial support that does not correspond to the surface layer;
c) lateral definition of the labels, on the set made up of the transfer support and the surface layer, by cutting done according to the thickness of the surface layer;
d) grasping one or several labels (16, 26, 36) to be transferred and their tearing off by input of energy in the corresponding zones of said set;
e) transfer and fixing of the label or set of labels torn off in stage d), on the final support (19, 29, 39);
**characterized in that**:
in stage c), cutting is carried out over the total thickness of the surface layer and over part of the thickness of the transfer support, so as to leave zones of said set which can be broken,
and in stage d) the supply of energy leads to the breaking of said zones of said set.

2. Process according to claim 1, **characterized by** the fact that the surface layer made up of an adhesion layer (13) covering the said elements, (11) stage a) includes the fixing of the transfer support (14) on the adhesion layer (13).

3. Process according to claim 2, **characterized by** the fact that the adhesion layer (13) is a double face adhesive film or a material chosen among glue, wax, silicon oxide and silicon.

4. Process according to claim 3, **characterized by** the fact that the glue is a glue chosen among polyimide, BCB and epoxy or photosensitive resin.

5. Process according to claim 2, **characterized by** the fact that the adhesion layer (13) covering the said elements (11) is a layer deposited and polished.

6. Process according to claim 1, **characterized by** the fact that, in stage a), the fixing is done by molecular adhesion.

7. Process according to claim 6, **characterized by** the fact that the fixing by molecular adhesion is reinforced by a thermal treatment.

8. Process according to claim 1, **characterized by** the fact that, in stage b), the removal of the part of the initial support (10, 20, 30) that does not correspond to the surface layer is carried out by one or several methods chosen among: mechanical rectification, polishing, dry or wet chemical attack, breaking along a weakened layer.

9. Process according to claim 1, **characterized by** the fact that the cutting is done by dry or wet chemical engraving, sawing, ultrasounds, cleaving or laser beam.

10. Process according to claim 1, **characterized by** the fact that, in stage d), the grasping is carried out by a technique involving mechanical means, capillarity, electrostatic means, pneumatic and/or chemical means.

11. Process according to claim 1, **characterized by** the fact that, in stage d), the input of energy is an input of mechanical and/or thermal and/or chemical energy.

12. Process according to claim 1, **characterized by** the fact that, in stage d), the tearing off is done by combining the effects of pressure and sucking up on the label(s) (16, 26, 36) to be transferred.

13. Process according to claim 1, **characterized by** the fact that, in stage e), the fixing is obtained by molecular adhesion or gluing.

14. Process according to claim 13, **characterized by** the fact that, in stage e), the fixing is obtained by gluing by means of glue, epoxy resin or a reactive or non-reactive metal layer.

15. Process according to claim 1, **characterized by** the fact that, in stage e), the part of the transfer support (14, 24) that corresponds to the label(s) transferred (16, 26) is removed at least partially.

16. Process according to claim 15, **characterized by**n the fact that the said removal, at least partial, of the part of the transfer support (16, 26) is carried out by one or several methods chosen among: lift-off technique, chemical or selective attack of the adhesion layer, application of mechanical forces and breaking along a weakened layer.

17. Process according to claim 1, **characterized by** the fact that, in stage c), we add to the transfer support (14), means (15) to keep it rigid during stage c).

18. Process according to claim 17, **characterized by** the fact that, in stage c), the means (15) making it possible to rigidify the transfer support (14) are removed at least partially.

19. Process according to claim 1, **characterized by** the fact that the surface layer includes at least a stoppage layer (12, 22, 32) adjacent to the part of the initial support (10, 20, 30) that does not correspond to the surface layer.

20. Process according to claim 19, **characterized by** the fact that the stoppage layer is also removed.

21. Process according to claim 1, **characterized by** the fact that, in stage a), the said element (11, 21, 31) constituent of a microelectronic and/or optoelectronic and/or acoustic and/or mechanical device, is tested to determine its working conditions.

22. Process according to claim 1, **characterized by** the fact that, in stage a), the fixing of the transfer support is obtained by depositing a layer of material on the surface layer, with that material layer forming the transfer support.

23. Process according to claim 1, **characterized by** the fact that, in stage c), the cutting is carried from the surface layer and/or from the transfer support.

24. Process according to claim 1, **characterized by** the fact that before the fixing on the final support of the label (s) (16, 26, 36), a surface preparation is done to improve the fixing.

25. Process according to claim 1, **characterized by** the fact that, in stage e), a stage is planned to reveal the said element (11, 21) constituent of the active or passive microelectronic and/or optoelectronic device and/or a sensor.

26. Process according to claim 1, **characterized by** the fact that since the initial support (20) is of the SOI type, that is to say, made up of a silicon substrate bearing successively a silicon oxide layer (22) and the silicon layer in which the said element is made (22), the silicon oxide layer is used as a stoppage layer.

27. Process according to claim 1, **characterized by** the fact that during the fixing on the final support, the label is aligned on that final support by using marks pre-established on the label and final support or by using a transfer support made of transparent material.
